# EUROPEAN PATENT SPECIFICATION

(11) **EP 3 644 446 B1**
(45) Date of publication and mention of the grant of the patent: **04.08.2021**
(21) Application number: 19204553.2
(22) Date of filing: 22.10.2019
(51) Int. Cl.: H01R 12/51, H01R 12/57, H01R 4/48

(54) **CONDUCTIVE TERMINAL AND CONNECTOR ASSEMBLY**
LEITFÄHIGE KLEMME UND STECKVERBINDERANORDNUNG
TERMINAL CONDUCTEUR ET ENSEMBLE CONNECTEUR

(30) Priority: 26.10.2018 CN 201811258797
(43) Date of publication of application: 29.04.2020
(73) Proprietor: Tyco Electronics (Shanghai) Co., Ltd., China (Shanghai) Pilot Free Trade Zone Shanghai (CN)
(72) Inventor: FU, Xiaozhi, Xuhui, Shanghai 200233 (CN); SHI, Ming, Xuhui, Shanghai 200233 (CN); JIANG, Hongtao, Xuhui, Shanghai 200233 (CN); ZHANG, Wei, Xuhui, Shanghai 200233 (CN); FAN, Dingbing, Xuhui, Shanghai 200233 (CN); WANG, Shuzhi, Xuhui, Shanghai 200233 (CN)
(74) Representative: Grünecker Patent- und Rechtsanwälte PartG mbB

(56) References cited:
- EP-A1- 3 179 566
- US-A1- 2014 120 783

## Description

### BACKGROUND OF THE INVENTION

### Field of the Invention

Embodiments of the present disclosure relate to a conductive terminal and a connector assembly comprising the same, in particular to a wire-to-board conductive terminal without a housing and a connector assembly comprising the same, and in more particular to a conductive terminal adapted to be electrically connected with a wire selectively inserted from a first or second direction and a connector assembly comprising the same.

### Description of the Related Art

In a relevant art, a wire is electrically connected to an electrical board generally by an electrical connector. US 2014120783 discloses a conductive terminal according to the preamble of claim 1. When being electrically connected to the electrical board, generally, a conductive terminal of the electrical connector is fixed in an insulating housing in advance, and then electrically connected to and fixed to the electrical board. However, such a connecting means is not only costly, but also causes the insulating housing occupying a larger space of the electrical board.

In order to overcome the deficiency, there is proposed, in the relevant art, an improved conductive terminal which may electrically connect the wire to the electrical board without housing covered. Nevertheless, an insertion direction of the wire is unchanged for the conductive terminal. For example, the conductive terminal only allows the wire to be inserted horizontally or vertically. With an increase in demand of customer, it is desired for a conductive terminal to allow the wire to be inserted therein both horizontally and vertically.

In addition, a current conductive terminal without housing has low locating and holding performance for the wire inserted therein, and thus the wire is easily disconnected therefrom.

Therefore, there is a need to a conductive terminal and connector assembly comprising the same that may solve the above problems.

### SUMMARY OF THE INVENTION

An objective of the present disclosure is to solve at least one aspect of the above mentioned problems and disadvantages occurred in the prior art.

According to the invention, there is provided a conductive terminal adapted to electrically connect a wire to a circuit board, comprising: a support frame adapted to define a receiving space therein; a pair of first clamping arms arranged in the receiving space, first clamping portions being formed at ends of the first clamping arms and adapted to selectively clamp a conductor of the wire inserted in a first insertion direction, so that the wire is electrically connected with the conductive terminal; and a pair of second clamping arms arranged in the receiving space, second clamping portions being formed at ends of the second clamping arms and adapted to selectively clamp the conductor of the wire inserted in a second insertion direction different from the first insertion direction, so that the wire is electrically connected with the conductive terminal.

According to an exemplary embodiment of the present disclosure, the first insertion direction is perpendicular to the second insertion direction.

According to an exemplary embodiment of the present disclosure, the support frame comprises a bottom wall and two side walls perpendicular to the bottom wall, the first insertion direction being parallel to a plane where the bottom wall is located, and the second insertion direction being perpendicular to the plane where the bottom wall is located.

According to an exemplary embodiment of the present disclosure, the support frame, the first clamping arm, and the second clamping arm are integrally formed from a single piece of sheet metal.

According to an exemplary embodiment of the present disclosure, the support frame further comprises a pair of cantilevers that are formed by bending inwardly from first ends of the two side walls, the pair of first clamping arms extending downstream in the first insertion direction and obliquely toward each other respectively from free ends of the cantilevers away from the first ends.

According to an exemplary embodiment of the present disclosure, the pair of second clamping arms extend downstream in the second insertion direction and obliquely toward each other respectively from sides of the cantilevers away from the bottom wall.

According to an exemplary embodiment of the present disclosure, the support frame further comprises a first end wall located at an upstream side in the first insertion direction and provided with a first insertion hole adapted to allow the conductor of the wire to be inserted therethrough in the first insertion direction.

According to an exemplary embodiment of the present disclosure, the bottom wall comprises a second insertion hole adapted to allow the conductor of the wire to be inserted therethrough in the second insertion direction.

According to an exemplary embodiment of the present disclosure, the support frame further a top wall, the two side walls being formed by bending perpendicularly downward from both sides of the top wall, the bottom wall being formed by bending perpendicularly from a lower side of at least one of the two side walls toward the other opposite to the side wall where the lower side is located, and the first end wall being formed by bending perpendicularly from one end of the top wall toward the bottom wall.

According to an exemplary embodiment of the present disclosure, the support frame further comprises a second end wall opposite to the first end wall and adapted to block the conductor of the wire inserted in the first insertion direction.

According to an exemplary embodiment of the present disclosure, the top wall is provided with a through hole to allow the conductor of the wire inserted in the second insertion direction to extend out of the conductive terminal.

According to an exemplary embodiment of the present disclosure, the first clamping arm and/or the second clamping arm further comprise a pair of release portions adapted to move in directions away from each other by an external force to spread the clamping portion.

According to an exemplary embodiment of the present disclosure, the top wall is provided with a release hole communicated with the release portion.

According to an exemplary embodiment of the present disclosure, the first and second clamping portions are provided with wire-penetrating portions adapted to clamp and penetrate an insulation layer of the wire to be electrically connected with the conductor.

According to an exemplary embodiment of another aspect of the present disclosure, there is provided a connector assembly, comprising: the conductive terminal according to any one of above embodiments; and a circuit board to which the conductive terminal is electrically connected, the circuit board being provided with a through hole, the second clamping arms of the conductive terminal being adapted to selectively clamp the conductor of the wire inserted through the through hole of the circuit board in the second insertion direction.

Other objectives and advantages of the present disclosure will become apparent from the following description of the present disclosure when taken in conjunction with the accompanying drawings, and may give a comprehensive understanding of the present disclosure.

### BRIEF DESCRIPTION OF THE DRAWINGS

The above and other features of the present disclosure will become more apparent by describing in detail exemplary embodiments thereof with reference to the accompanying drawings, in which:
Fig. 1 is a perspective view of a connector assembly comprising a conductive terminal and an electrical board according to an exemplary embodiment of the present disclosure;
Fig. 2 is a perspective view of the conductive terminal of Fig. 1, wherein, for the sake of observation, a top wall of the conductive terminal is not shown;
Fig. 3 is a top view of the conductive terminal of Fig. 1, wherein, for the sake of observation, a top wall of the conductive terminal is not shown;
Fig. 4 is a cross-sectional view of the conductive terminal of Fig. 1 taken along a plane A-A of Fig. 3;
Fig. 5 is a perspective view of the conductive terminal of Fig. 1;
Fig. 6 is a schematic view of the connector assembly of Fig. 1, wherein a conductor of a wire is inserted into the connector assembly in a first insertion direction;
Fig. 7 is a schematic view of the connector assembly of Fig. 6, wherein, for the sake of observation, the top wall of the conductive terminal is not shown;
Fig. 8 is a schematic view of the connector assembly of Fig. 1, wherein the conductor of the wire is inserted into the connector assembly in a second insertion direction; and
Fig. 9 is a cross-sectional perspective view of the connector assembly of Fig. 8 taken along the plane A-A of Fig. 3.

### DETAILED DESCRIPTION OF PREFERRED EMBODIMENTS OF THE INVENTION

The technical solution of the present disclosure will be described hereinafter in further detail with reference to the following embodiments, taken in conjunction with the accompanying drawings. In the specification, the same or similar reference numerals indicate the same or similar parts. The description of the embodiments of the present disclosure hereinafter with reference to the accompanying drawings is intended to explain the general inventive concept of the present disclosure, and should not be constructed as a limitation to the present disclosure.

In addition, in the following detailed description, for the sake of explanation, numerous specific details are set forth in order to provide a thorough understanding of the disclosed embodiments. It will be apparent, however, one or more embodiments may also be practiced without these specific details. In other instances, well-known structures and devices are illustrated schematically in order to simplify the drawing.

According to a general technical concept of the present disclosure, there is provided a conductive terminal adapted to electrically connect a wire to a circuit board, comprising: a support frame adapted to define a receiving space therein; a pair of first clamping arms arranged in the receiving space, first clamping portions being formed at ends of the first clamping arms and adapted to selectively clamp a conductor of the wire inserted in a first insertion direction, so that the wire is electrically connected with the conductive terminal; and a pair of second clamping arms arranged in the receiving space, second clamping portions being formed at ends of the second clamping arms and adapted to selectively clamp the conductor of the wire inserted in a second insertion direction different from the first insertion direction, so that the wire is electrically connected with the conductive terminal.

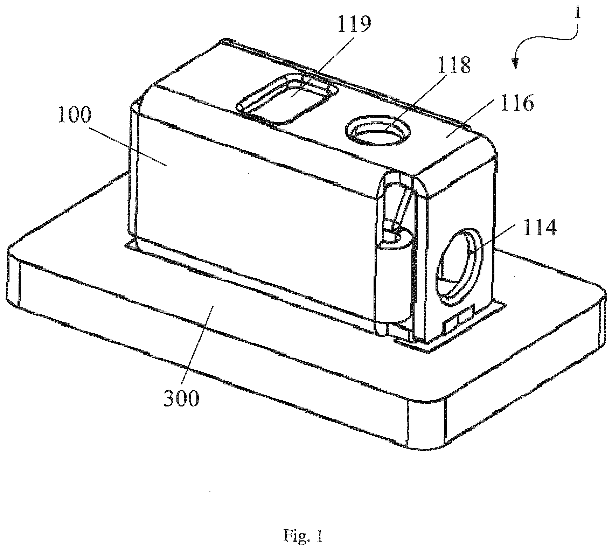

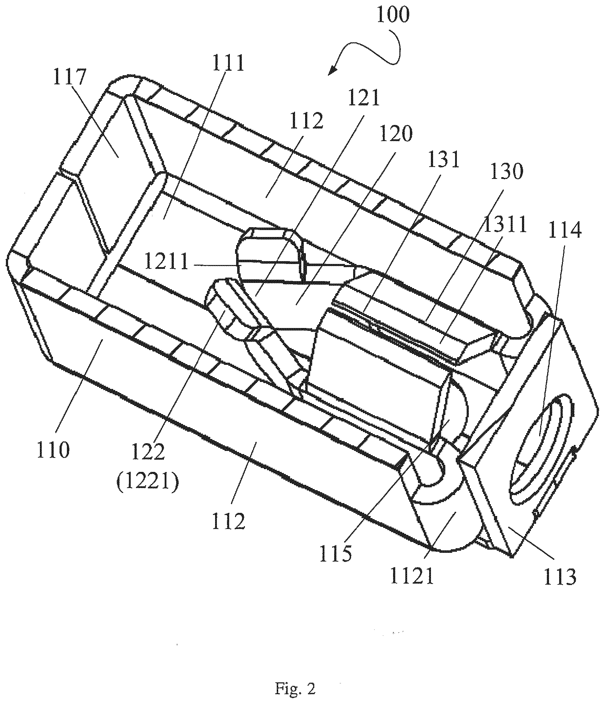

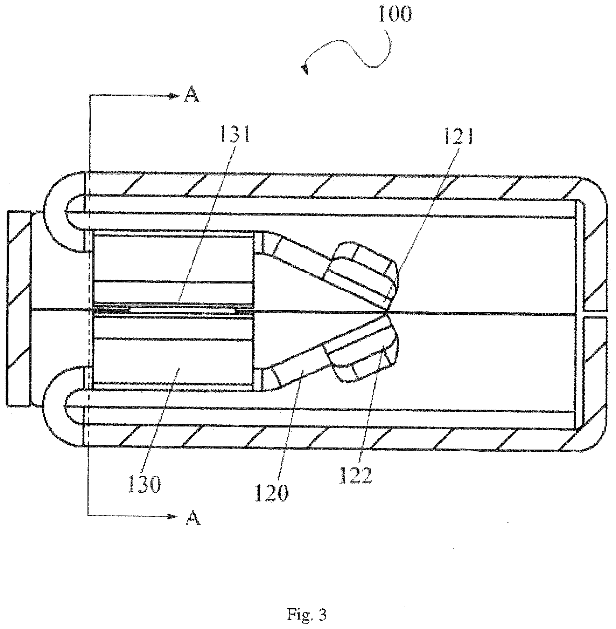

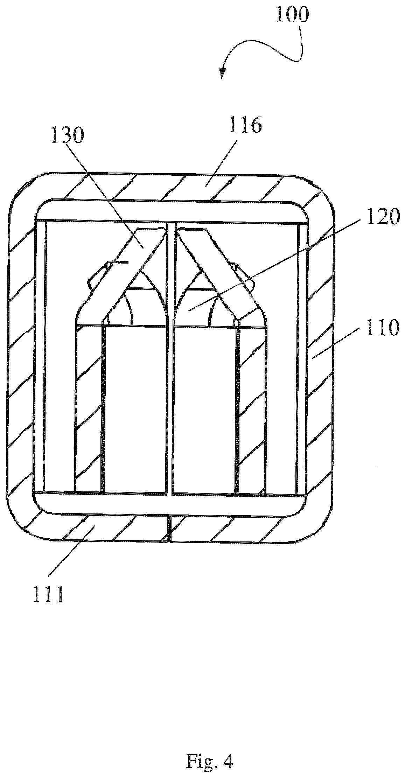

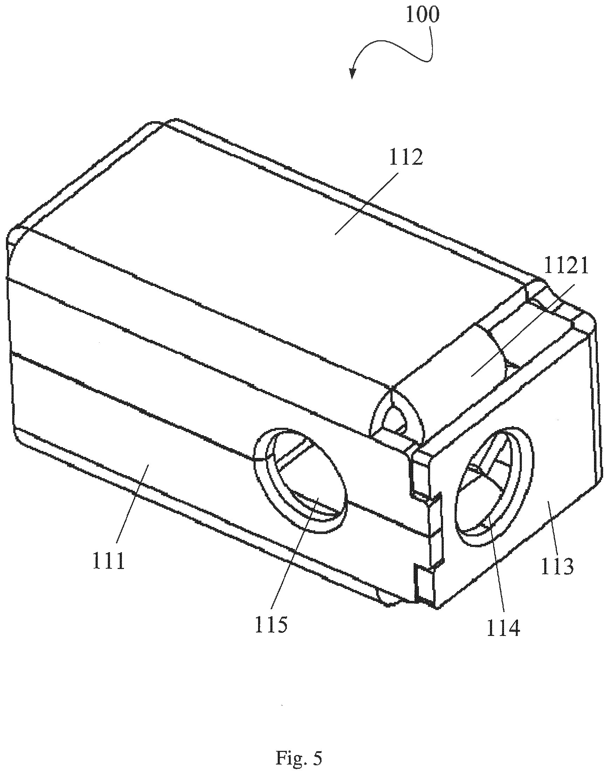

Fig. 1 is a perspective view of a connector assembly comprising a conductive terminal and an electrical board according to an exemplary embodiment of the present disclosure; Fig. 2 is a perspective view of the conductive terminal of Fig. 1, wherein, for the sake of observation, a top wall of the conductive terminal is not shown; Fig. 3 is a top view of the conductive terminal of Fig. 1, wherein, for the sake of observation, a top wall of the conductive terminal is not shown; Fig. 4 is a cross-sectional view of the conductive terminal of Fig. 1 taken along a plane A-A of Fig. 3; and Fig. 5 is a perspective view of the conductive terminal of Fig. 1.

As shown in Figs. 1-5, in an exemplary embodiment of the present disclosure, there is provided a conductive terminal 100 adapted to electrically connect a wire 200 to a circuit board 300. The conductive terminal 100 comprises a support frame 110, a pair of first clamping arms 120 and a pair of second clamping arms 130. The support frame 110 defines a receiving space therein where the pair of first clamping arms 120 and the pair of second clamping arms 130 are arranged. A pair of first clamping portions 121 are formed at ends of the pair of first clamping arms 120 and adapted to selectively clamp a conductor 210 of the wire 200 inserted in a first insertion direction, so that the wire 200 is electrically connected with the conductive terminal 100. A pair of second clamping portions 131 are formed at ends of the pair of second clamping arms 130 and adapted to selectively clamp the conductor 210 of the wire 200 inserted in a second insertion direction different from the first insertion direction, so that the wire is electrically connected with the conductive terminal.

As shown in Figs. 1-5, in an exemplary embodiment of the present disclosure, the support frame 110 comprises: a bottom wall 111; two side walls 112; a first end wall 113 at a first end (a right end in Figs. 1 and 2) of the support frame; a second end wall 117 at a second end (a left end in Figs. 1 and 2) of the support frame and opposite to the first end wall 113; and a top wall 116. In an embodiment, the side wall 112 is perpendicular to the bottom wall 111. In an illustrated embodiment, the two side walls 112 are formed by bending perpendicularly downward from both sides of the top wall 116. The bottom wall 111 is formed by bending perpendicularly from a lower side of at least one of the two side walls toward the other opposite to the side wall where the lower side is located. The first end wall 113 is formed by perpendicularly bending from one end of the top wall 116 toward the bottom wall. In an embodiment, the second end wall 117 is formed by bending perpendicularly from the other end of the top wall 116 toward the bottom wall. In an alternative embodiment, the second end wall 117 is formed by bending from one end of the two side walls 112 towards each other in a direction perpendicular to a plane where the side walls 112 are located.

In an embodiment, the support frame 110, the first clamping arm 120, and the second clamping arm 130 are integrally formed from a single piece of sheet metal. The conductive terminal 100 is formed from a single metal sheet such as a copper sheet by shearing, stamping, and bending processes.

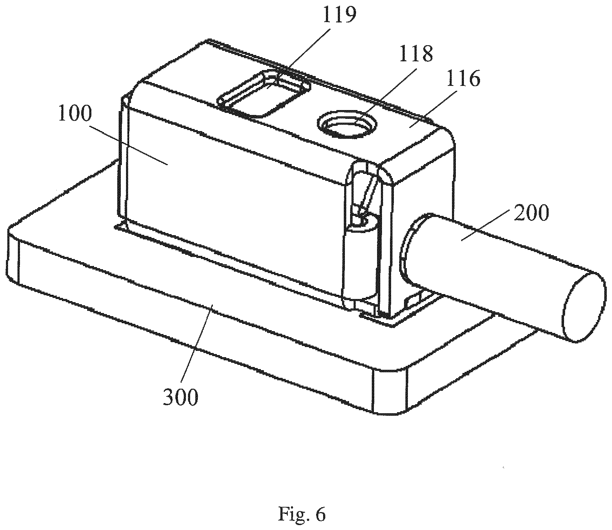

In the illustrated embodiment, the first insertion direction is perpendicular to the second insertion direction (as shown in Figs. 6-9). Specifically, the first insertion direction is parallel to the plane where the bottom wall 111 is located, and the second insertion direction is perpendicular to the plane where the bottom wall 111 is located. In an embodiment, the first insertion direction is a horizontal direction and the second insertion direction is a vertical direction. In a further embodiment, the first insertion direction and the second insertion direction may be non-perpendicular, for example, the first insertion direction is a direction intersecting the plane where the bottom wall 111 is located at an angle other than 90 degrees.

As shown in Figs. 1-5, in an exemplary embodiment of the present disclosure, the support frame 110 further includes a pair of cantilevers 1121 that are formed by bending inwardly from the first ends of the two side walls 112. In an embodiment, the pair of first clamping arms 120 extend downstream in the first insertion direction and obliquely toward each other respectively from free ends of the cantilevers away from the first ends of the side wall 112.

In an embodiment, the pair of second clamping arms 130 extend downstream in the second insertion direction and obliquely toward each other respectively from sides of the cantilevers away from the bottom wall 111. In the illustrated embodiment, the pair of first clamping arms 120 extend obliquely toward each other respectively from the free ends of the cantilevers 1121 away from the first end of the side wall 112 toward second ends of the side walls 112 opposite to the first end; and the pair of second clamping arms 130 extend obliquely upwardly toward each other respectively from sides of the cantilevers 1121 away from the bottom wall.

In an alternative embodiment, the support frame 110 includes two pairs of cantilevers 1121 that are respectively formed by bending inwardly from the first ends of the two side walls. In this case, the pair of first clamping arms 120 extend downstream in the first insertion direction and obliquely toward each other respectively from the free ends of one of one pair of the cantilevers away from the first end of the side wall; and the pair of second clamping arms extend downstream in the second insertion direction obliquely toward each other respectively from the sides of one of the other pair of the cantilevers away from the bottom wall.

As shown in Figs. 1-5, in an exemplary embodiment of the present disclosure, the first end wall 113 is located at the first end of the support frame, and is provided with a first insertion hole 114 adapted to allow the conductor 210 of the wire 200 to be inserted therethrough in the first insertion direction.

As shown in Figs. 1-5, in an exemplary embodiment of the present disclosure, the bottom wall 111 is provided with a second insertion hole 115 adapted to allow the conductor 210 of the wire 200 to be inserted therethrough in the second insertion direction. In the illustrated embodiment, the second insertion hole 115 is aligned with the second clamping arm 130. In an alternative embodiment, the second insertion hole 115 may be not aligned with the second clamping arm 130.

As shown in Figs. 1-5, in an exemplary embodiment of the present disclosure, the top wall 116 is provided with a through hole 118 to allow the conductor 210 of the wire 200 inserted in the second insertion direction to extend out of the conductive terminal 100. In the illustrated embodiment, the second insertion hole 115 is aligned with the second clamping arm 130 and the through hole 118. In an alternative embodiment, the second insertion hole 115 may be not aligned with the second clamping arm 130 and the through hole 118.

In an embodiment, the top wall 116 may not be provided with the through hole, in this case, the conductor of the wire inserted in the second insertion direction is received in the receiving space of the support frame. In this way, the top wall may block a further movement in the second insertion direction of the conductor that has been inserted into the conductive terminal in the second insertion direction.

As shown in Figs. 1-5, in an exemplary embodiment of the present disclosure, the second end wall 117 may block a further movement in the first insertion direction of the conductor 210 that has been inserted into the conductive terminal in the first insertion direction. In an embodiment, the second end wall may be provided with a through hole, so that the conductor of the wire inserted in the first insertion direction may extend out of the through hole.

As shown in Figs. 1-5, in an exemplary embodiment of the present disclosure, the first clamping portions 121 are provided with wire-penetrating portions 1211, and the second clamping portions 131 are provided with wire-penetrating portions 1311. The wire-penetrating portions are adapted to clamp and penetrate an insulation layer of the wire 200 to be electrically connected with the conductor 210, and prevent the conductor from being pulled from the first insertion hole 114 or the second insertion hole 115. With this arrangement, the conductor 210 of the wire 200 may be reliably held in the conductive terminal 100.

As shown in Figs. 1-5, in an exemplary embodiment of the present disclosure, the first clamping arm 120 and/or the second clamping arm 130 further comprise a release portion. The release portion is adapted to move in a direction away from each other by an external force to spread the clamping portions 121 or 131, thereby releasing the wire. In an embodiment, the release portion of the first clamping arm 120 includes an arc portion formed on a side of at least one of the pair of the first clamping arms 120 away from the bottom wall 111.

In the illustrated embodiment, a release portion 122 of the first clamping arm 120 includes two arc portions 1221 respectively formed on the sides of the pair of the first clamping arms 120. The arc portions 1221 are deflected outwardly away from each other.

In a further embodiment, the release portion of the second clamping arm 130 includes an arc portion formed on at least one of the two ends of the second clamping portion 131. In a further embodiment, the release portion of the second clamping arm 130 includes two arc portions respectively formed on the two ends of the second clamping portion 131. The arc portions are deflected outwardly away from each other.

As shown in Figs. 1-5, in an exemplary embodiment of the present invention, the top wall 116 is provided with a release hole, and an external release tool is adapted to drive the release portion through the release hole and cause the release portion to move in directions away from each other to release the wire. In the illustrated embodiment, the top wall 116 is provided with a release hole 119 that is aligned with the release portion 121 of the first clamp arm 120. In an alternative embodiment, the release hole 119 may be not aligned with the release portion 121 of the first clamp arm 120. In a further embodiment, the top wall is further provided with a release hole that is aligned with the release portion of the second clamp arm 130.

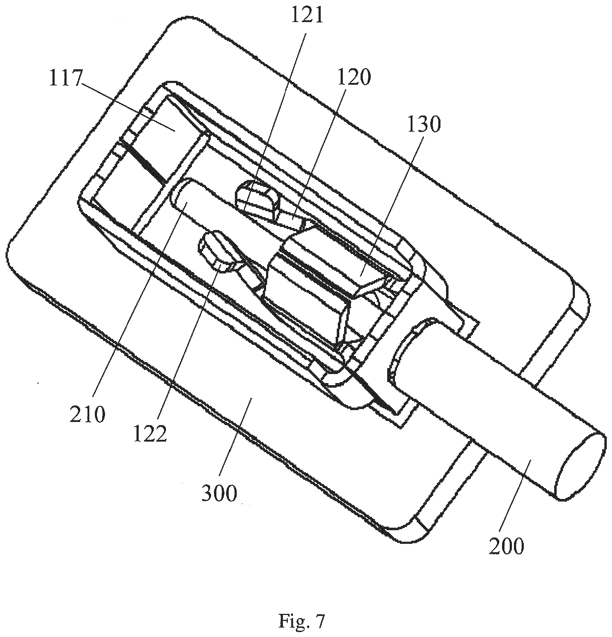

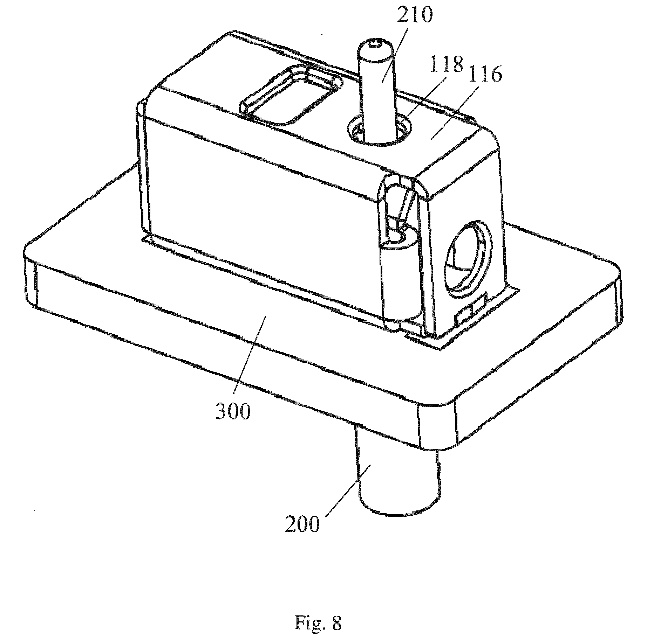

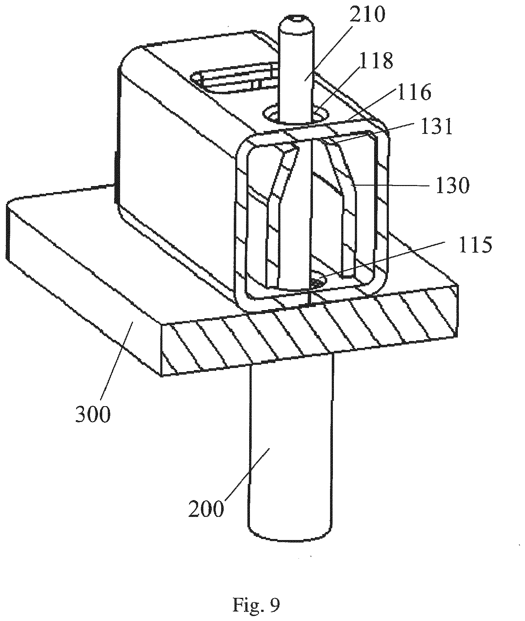

Fig. 6 is a schematic view of the connector assembly of Fig. 1, wherein a conductor of a wire is inserted into the connector assembly in a first insertion direction; Fig. 7 is a schematic view of connector assembly of Fig. 6, wherein, for the sake of observation, the top wall of the conductive terminal is not shown; Fig. 8 is a schematic view of the connector assembly of Fig. 1, wherein the conductor of the wire is inserted into the connector assembly in a second insertion direction; and Fig. 9 is a cross-sectional perspective view of the connector assembly of Fig. 8 taken along the plane A-A of Fig. 3.

As shown in Figs. 1 and 6-9, in an exemplary embodiment of the present disclosure, there is provided a connector assembly 1 comprising the conductive terminal 100 and the circuit board 300, the conductive terminal 100 being electrically connected to the circuit board 300. The conductive terminal is the one of any of the embodiments. The circuit board 300 is provided with a through hole. The second clamping arm 130 of the conductive terminal 100 is adapted to selectively clamp the conductor 210 of the wire 200 inserted through the through hole of the circuit board 300 from the second insertion direction.

In an exemplary embodiment, with suction nozzles of the vacuum adsorption apparatus sucking the top wall 116 of the support frame 110 of the conductive terminal 100, the bottom wall 11 of the support frame 110 is fitted with a surface of the circuit board 300, the second insertion hole 115 of the conductive terminal 100 is aligned with the through hole of the circuit board 300, and then the conductive terminal 100 is soldered to solder pads of the circuit board 300 by surface mount technology (SMT). Therefore, a reliable electrical connection between the conductive terminals 100 and the circuit board 300 is achieved.

As shown in Figs. 6 and 7, in an exemplary embodiment, during inserting the wire 200 into the conductive terminal 100 in the first insertion direction (in a horizontal direction in the illustrated embodiment), the conductor 210 of the wire is inserted into the conductive terminal 100 from the insertion hole 114 and clamped by the pair of first clamping arms 120. And, the wire-penetrating portion 1211 of the first clamping portion 121 of the first clamping arm 120 penetrates an insulation layer of the wire 200, such that the wire 200 is reliably held and electrically connected with the conductive terminal. In an embodiment, during releasing the wire 200 from the conductive terminal, the external release tool passes through the release hole 119 to drive the release portion 122, so that the release portion 122 moves towards the directions away from each other, the clamp portion 121 clamping the wire 200 is spread, and thus the wire 200 is released. In an embodiment, an end of the external release tool is a plate member. In an embodiment, the external release tool may comprise a screwdriver.

As shown in Figs. 8 and 9, in an exemplary embodiment, during inserting the wire 200 into the conductive terminal 100 in the second insertion direction (in a vertical direction in the illustrated embodiment), the conductor 210 of the wire passes through the through hole of the circuit board, and is inserted into the conductive terminal 100 from the second insertion hole 115 in the second insertion direction and clamped by the pair of second clamping arms 130. And, the wire-penetrating portion 1311 of the second clamping portion 131 of the second clamping arm 130 penetrates an insulation layer of the wire 200, such that the wire 200 is reliably held and electrically connected with the conductive terminal.

In such a way, the conductive terminal of the present disclosure allows the wire to be inserted selectively from the first or second insertion direction, so as to meet the requirement of inserting the wire from two directions.

Although the present disclosure has been described with reference to the attached drawings, the embodiments disclosed in the drawings are intended to illustrate the preferred embodiments of the present disclosure, but should not be constructed as a limitation to the present disclosure.

Although several exemplary embodiments have been shown and described, it would be appreciated by those skilled in the art that various changes or modifications may be made within the scope of the claims.

It should be noted that term "comprising" or "including" should be understood as not excluding other elements or steps, and term "a" or "an" should be understood as not excluding plural elements or steps. Further, any reference numerals in claims should not be understood as a limitation to the present disclosure.

## Claims

1. A conductive terminal (100) adapted to electrically connect a wire (200) to a circuit board (300), comprising:
a support frame (110) adapted to define a receiving space therein;
a pair of first clamping arms (120) arranged in the receiving space, first clamping portions (121) being formed at ends of the first clamping arms and adapted to selectively clamp a conductor (210) of the wire inserted in a first insertion direction, so that the wire is electrically connected with the conductive terminal; and
**characterized by**:
a pair of second clamping arms (130) arranged in the receiving space, second clamping portions (131) being formed at ends of the second clamping arms and adapted to selectively clamp the conductor of the wire inserted in a second insertion direction different from the first insertion direction, so that the wire is electrically connected with the conductive terminal.

2. The conductive terminal according to claim 1, wherein, the first insertion direction is perpendicular to the second insertion direction.

3. The conductive terminal according to claim 2, wherein, the support frame comprises a bottom wall (111) and two side walls (112) perpendicular to the bottom wall, the first insertion direction being parallel to a plane where the bottom wall is located, and the second insertion direction being perpendicular to the plane where the bottom wall is located.

4. The conductive terminal according to claim 1, wherein, the support frame (110), the first clamping arm (120) and the second clamping arm (130) are integrally formed from a single piece of sheet metal.

5. The conductive terminal according to claim 3, wherein, the support frame further comprises a pair of cantilevers (1121) that are formed by bending inwardly from first ends of the two side walls (112), the pair of first clamping arms (120) extending downstream in the first insertion direction and obliquely toward each other from free ends of the cantilevers away from the first ends.

6. The conductive terminal according to claim 5, wherein, the pair of second clamping arms (130) extend downstream in the second insertion direction and obliquely toward each other from sides of the cantilevers away from the bottom wall (111).

7. The conductive terminal according to claim 3, wherein, the support frame further comprises a first end wall (113) located at an upstream side in the first insertion direction and provided with a first insertion hole (114) adapted to allow the conductor (210) of the wire to be inserted therethrough in the first insertion direction.

8. The conductive terminal according to claim 3, wherein, the bottom wall (111) comprises a second insertion hole (115) adapted to allow the conductor of the wire to be inserted therethrough in the second insertion direction.

9. The conductive terminal according to claim 7, wherein, the support frame further a top wall (116), the two side walls (112) being formed by bending perpendicularly downward from both sides of the top wall, the bottom wall (111) being formed by bending perpendicularly from a lower side of at least one of the two side walls toward the other opposite to the side wall where the lower side is located, and the first end wall being formed by bending perpendicularly from one end of the top wall toward the bottom wall.

10. The conductive terminal according to claim 7, wherein, the support frame further comprises a second end wall (117) opposite to the first end wall (113) and adapted to block the conductor of the wire inserted in the first insertion direction.

11. The conductive terminal according to claim 9, wherein, the top wall (116) is provided with a through hole (118) to allow the conductor of the wire inserted in the second insertion direction to extend out of the conductive terminal.

12. The conductive terminal according to claim 9, wherein, the first clamping arm and/or the second clamping arm further comprise a pair of release portions (122) adapted to move in directions away from each other by an external force to spread the clamping portions (121, 131).

13. The conductive terminal according to claim 12, wherein, the top wall (116) is provided with a release hole (119) communicated with the release portion (122).

14. The conductive terminal according to claim 1, wherein, the first and second clamping portions are provided with wire-penetrating portions (1211, 1311) adapted to clamp and penetrate an insulation layer of the wire to be electrically connected with the conductor.

15. A connector assembly (1), comprising:
the conductive terminal according to claim 1; and
a circuit board (300) to which the conductive terminal (100) is electrically connected, the circuit board being provided with a through hole, the second clamping arms (130) of the conductive terminal being adapted to selectively clamp the conductor of the wire inserted through the through hole of the circuit board in the second insertion direction.

## Patentansprüche

1. Leitender Anschluss (100), der zum elektrischen Verbinden eines Drahtes (200) mit einer Leiterplatte (300) eingerichtet ist, wobei er umfasst:
einen Tragerahmen (110), der zum Ausbilden eines Aufnahmeraums darin eingerichtet ist;
ein Paar erster Klemm-Arme (120), die in dem Aufnahmeraum angeordnet sind, wobei erste Klemm-Abschnitte (121) an Enden der ersten Klemm-Arme ausgebildet und so eingerichtet sind, dass sie einen Leiter (210) des Drahtes, der in einer ersten Einführrichtung eingeführt ist, selektiv so festklemmen, dass der Draht elektrisch mit dem leitenden Anschluss verbunden wird, und **gekennzeichnet durch**:
ein Paar zweiter Klemm-Arme (130), die in dem Aufnahmeraum angeordnet sind, wobei zweite Klemm-Abschnitte (131) an Enden der zweiten Klemm-Arme ausgebildet und so eingerichtet sind, dass sie den Leiter des Drahtes, der in einer zweiten Einführungsrichtung eingeführt ist, die sich von der ersten Einführungsrichtung unterscheidet, selektiv so festklemmen, dass der Draht elektrisch mit dem leitenden Anschluss verbunden wird.

2. Leitender Anschluss nach Anspruch 1, wobei die erste Einführungsrichtung senkrecht zu der zweiten Einführungsrichtung ist.

3. Leitender Anschluss nach Anspruch 2, wobei der Tragerahmen eine Bodenwand (111) sowie zwei Seitenwände senkrecht zu der Bodenwand (112) umfasst, die erste Einführungsrichtung parallel zu einer Ebene ist, in der sich die Bodenwand befindet, und die zweite Einführungsrichtung senkrecht zu der Ebene ist, in der sich die Bodenwand befindet.

4. Leitender Anschluss nach Anspruch 1, wobei der Tragerahmen (110), der erste Klemm-Arm (120) und der zweite Klemm-Arm (130) integral aus einem Blechteil ausgebildet sind.

5. Leitender Anschluss nach Anspruch 3, wobei der Tragerahmen des Weiteren ein Paar Ausleger (1121) umfasst, die ausgebildet werden, indem sie von ersten Enden der zwei Seitenwände (112) nach innen gebogen werden, und sich die paarigen ersten Klemm-Arme (120) in der ersten Einführungsrichtung stromab und schräg zueinander von freien Enden der Ausleger von den ersten Enden weg erstrecken.

6. Leitender Anschluss nach Anspruch 5, wobei sich die paarigen zweiten Klemm-Arme (130) in der zweiten Einführungsrichtung stromab und schräg zueinander von Seiten der Ausleger von der Bodenwand (111) weg erstrecken.

7. Leitender Anschluss nach Anspruch 3, wobei der Tragerahmen des Weiteren eine erste Stirnwand (113) umfasst, die sich an einer stromauf liegenden Seite in der ersten Einführungsrichtung befindet und mit einem ersten Einführungs-Loch (114) versehen ist, das so eingerichtet ist, dass es zulässt, dass der Leiter (210) des Drahtes in der ersten Einführrichtung durch selbiges hindurch eingeführt wird.

8. Leitender Anschluss nach Anspruch 3, wobei die Bodenwand (111) ein zweites Einführungs-Loch (115) umfasst, das so eingerichtet ist, dass es zulässt, dass der Leiter des Drahtes in der zweiten Einführungsrichtung durch selbiges hindurch eingeführt wird.

9. Leitender Anschluss nach Anspruch 7, wobei der Tragerahmen des Weiteren eine obere Wand (116) aufweist, und die zwei Seitenwände (112) ausgebildet werden, indem sie von beiden Seiten der oberen Wand nach unten gebogen werden,
die Bodenwand (111) ausgebildet wird, indem sie von einer unteren Seite wenigstens einer der zwei Seitenwände senkrecht auf die andere zu gebogen wird, die der Seitenwand gegenüberliegt, an der sich die untere Seite befindet, und
die erste Stirnwand ausgebildet wird, indem sie senkrecht von einem Ende der oberen Wand auf die Bodenwand zu gebogen wird.

10. Leitender Anschluss nach Anspruch 7, wobei der Tragerahmen des Weiteren eine zweite Stirnwand (117) umfasst, die der ersten Stirnwand (113) gegenüberliegt und so eingerichtet ist, dass sie den Leiter des in der ersten Einführungsrichtung eingeführten Drahtes blockiert.

11. Leitender Anschluss nach Anspruch 9, wobei die obere Wand (116) mit einem Durchgangs-Loch (118) versehen ist, das zulässt, dass sich der Leiter des Drahtes, der in der zweiten Einführungsrichtung eingeführt ist, von dem leitenden Anschluss nach außen erstreckt.

12. Leitender Anschluss nach Anspruch 9, wobei der erste Klemm-Arm und/oder der zweite Klemm-Arm des Weiteren ein Paar von Freigabe-Abschnitten (122) umfassen/umfasst, die so eingerichtet sind, dass sie sich durch eine Kraft von außen in Richtungen voneinander weg bewegen und die Klemm-Abschnitte (121, 131) spreizen.

13. Leitender Anschluss nach Anspruch 12, wobei die obere Wand (116) mit einem Freigabe-Loch (119) versehen ist, das mit dem Freigabe-Abschnitt (122) in Verbindung steht.

14. Leitender Anschluss nach Anspruch 1, wobei der erste und der zweite Klemm-Abschnitt mit Abschnitten (1211, 1311) zum Durchdringen des Drahtes versehen sind, die so eingerichtet sind, dass sie eine Isolierungsschicht des Drahtes festklemmen und durchdringen und elektrisch mit dem Leiter verbunden werden.

15. Verbinder-Anordnung (1), die umfasst:
den leitenden Anschluss nach Anspruch 1; sowie
eine Leiterplatte (300), mit der der leitende Anschluss (100) elektrisch verbunden ist, wobei die Leiterplatte mit einem Durchgangsloch versehen ist, und die zweiten Klemm-Arme (130) des leitenden Anschlusses so eingerichtet sind, dass sie den Leiter des Drahtes, der über das Durchgangsloch der Leiterplatte in der zweiten Einführungsrichtung eingeführt ist, selektiv festklemmen.

## Revendications

1. Terminal conducteur (100) adapté pour connecter électriquement un fil (200) à une carte de circuits (300), comprenant :
une structure de soutien (110) adaptée pour définir un espace de réception en celle-ci ;
une paire de premiers bras de serrage (120) disposés dans l'espace de réception, des premières parties de serrage (121) étant formées à des extrémités des premiers bras de serrage et adaptées pour serrer sélectivement un conducteur (210) du fil inséré dans une première direction d'insertion, de sorte que le fil soit électriquement connecté au terminal conducteur ; et
**caractérisé par** :
une paire de deuxièmes bras de serrage (130) disposés dans l'espace de réception, des deuxièmes parties de serrage (131) étant formées à des extrémités des deuxièmes bras de serrage et adaptées pour serrer sélectivement le conducteur du fil inséré dans une deuxième direction d'insertion différente de la première direction d'insertion, de sorte que le fil soit électriquement connecté au terminal conducteur.

2. Le terminal conducteur selon la revendication 1, dans lequel, la première direction d'insertion est perpendiculaire à la deuxième direction d'insertion.

3. Le terminal conducteur de la revendication 2, dans lequel, la structure de soutien comprend une paroi de fond (111) et deux parois latérales (112) perpendiculaires à la paroi de fond, la première direction d'insertion étant parallèle à un plan sur lequel se trouve la paroi de fond, et la deuxième direction d'insertion étant perpendiculaire au plan sur lequel se trouve la paroi de fond.

4. Le terminal conducteur selon la revendication 1, dans lequel, la structure de soutien (110), le premier bras de serrage (120) et le deuxième bras de serrage (130) sont intégralement formés à partir d'une pièce unique de feuille métallique.

5. Le terminal conducteur selon la revendication 3, dans lequel, la structure de soutien comprend en outre une paire de cantilevers (1121) qui sont formés par coudage vers l'intérieur depuis de premières extrémités des deux parois latérales (112), la paire de premiers bras de serrage (120) s'étendant vers l'aval dans la première direction d'insertion et obliquement l'une vers l'autre depuis des extrémités libres des cantilevers en s'éloignant des premières extrémités.

6. Le terminal conducteur selon la revendication 5, dans lequel, la paire de deuxièmes bras de serrage (130) s'étendent vers l'aval dans la deuxième direction d'insertion et obliquement l'un vers l'autre depuis des côtés des cantilevers éloignés de la paroi de fond (111) .

7. Le terminal conducteur selon la revendication 3, dans lequel, la structure de soutien comprend en outre une première paroi d'extrémité (113) située sur un côté amont dans la première direction d'insertion et dotée d'un premier trou d'insertion (114) adapté pour permettre une insertion du conducteur (210) du fil à travers celle-ci dans la première direction d'insertion.

8. Le terminal conducteur selon la revendication 3, dans lequel, la paroi de fond (111) comprend un deuxième trou d'insertion (115) adapté pour permettre une insertion du conducteur du fil à travers celle-ci dans la deuxième direction d'insertion.

9. Le terminal conducteur selon la revendication 7, dans lequel, la structure de soutien comprend en outre une paroi sommitale (116), les deux parois latérales (112) étant formées par coudage perpendiculairement vers le bas depuis les deux côtés de la paroi sommitale, la paroi de fond (111) étant formée par coudage perpendiculairement depuis un côté inférieur d'au moins une des deux parois latérales vers l'autre opposée à la paroi latérale sur laquelle le côté inférieur est situé, et la première paroi d'extrémité étant formée par coudage perpendiculairement depuis une extrémité de la paroi sommitale vers la paroi de fond.

10. Le terminal conducteur selon la revendication 7, dans lequel, la structure de soutien comprend en outre une deuxième paroi d'extrémité (117) opposée à la première paroi d'extrémité (113) et adaptée pour bloquer le conducteur du fil inséré dans la première direction d'insertion.

11. Le terminal conducteur selon la revendication 9, dans lequel, la paroi sommitale (116) est dotée d'un trou traversant (118) pour permettre au conducteur du fil inséré dans la deuxième direction d'insertion de s'étendre hors du terminal conducteur.

12. Le terminal conducteur selon la revendication 9, dans lequel, le premier bras de serrage et/ou le deuxième bras de serrage comprennent en outre une paire de parties de libération (122) adaptées pour se déplacer dans des directions s'éloignant l'une de l'autre par application d'une force externe pour écarter les parties de serrage (121, 131).

13. Le terminal conducteur selon la revendication 12, dans lequel, la paroi sommitale (116) est dotée d'un trou de libération (119) communiquant avec la partie de libération (122).

14. Le terminal conducteur selon la revendication 1, dans lequel, les première et deuxième parties de serrage sont dotées de parties de pénétration de fil (1211, 1311) adaptées pour serrer et pénétrer une couche isolante du fil pour être électriquement connectées au conducteur.

15. Assemblage de connecteur (1), comprenant :
le terminal conducteur selon la revendication 1 ; et
une carte de circuits (300) à laquelle le terminal conducteur (100) est électriquement connecté, la carte de circuits étant dotée d'un trou traversant, les deuxièmes bras de serrage (130) du terminal connecteur étant adaptés pour serrer sélectivement le conducteur du fil inséré à travers le trou traversant de la carte de circuits dans la deuxième direction d'insertion.
